(19) Europäisches Patentamt / European Patent Office / Office européen des brevets

(11) **EP 0 909 956 B1**

(12) **EUROPÄISCHE PATENTSCHRIFT**

(45) Veröffentlichungstag und Bekanntmachung des Hinweises auf die Patenterteilung:
**14.11.2007 Patentblatt 2007/46**

(51) Int Cl.:
***G01R 27/16*** *(2006.01)*

(21) Anmeldenummer: **98118266.0**

(22) Anmeldetag: **26.09.1998**

(54) **Verfahren und Bestimmung des Schleifenwiderstands eines Stromversorgungsnetzes**

Process and measuring the loop resistance of a distribution network

Procédé et détermination de la résistance d'un réseau de distribution électrique

(84) Benannte Vertragsstaaten:
**AT CH DE FR GB IT LI**

(30) Priorität: **18.10.1997 DE 19746200**

(43) Veröffentlichungstag der Anmeldung:
**21.04.1999 Patentblatt 1999/16**

(73) Patentinhaber: **Ch. Beha GmbH Technische Neuentwicklungen**
**79286 Glottertal (DE)**

(72) Erfinder:
• **Hofstetter, Christoph, Dipl.-Ing.**
**79336 Herbolzheim-Wagenstadt (DE)**
• **Henninger, Frank**
**79115 Freiburg (DE)**

(74) Vertreter: **Patentanwälte**
**Westphal, Mussgnug & Partner**
**Am Riettor 5**
**78048 Villingen-Schwenningen (DE)**

(56) Entgegenhaltungen:
| | |
|---|---|
| **EP-A- 0 295 800** | **EP-A- 0 881 500** |
| **WO-A-95/01573** | **DD-A- 274 681** |
| **DE-A- 4 013 490** | **DE-B- 1 237 218** |
| **DE-B- 1 256 319** | **DE-B- 1 257 960** |
| **DE-B- 1 287 211** | |

**Beschreibung**

Die Erfindung betrifft ein Verfahren zur Bestimmung des Schleifenwiderstands eines Stromversorgungsnetzes der im Oberbegriff des Anspruchs 1 bzw. des Anspruchs 7 genannten Art.

Ein solches Verfahren ist beispielsweise aus EP 0 295 800 B1 bekannt. Dort wird zur zeitweiligen Abschaltung eines Reststrom-Leistungsschalters eine magnetisch gekoppelte Fühlerschaltung in einem Wechselstromkreis eingesetzt. Bei dem Verfahren wird eine Gleichsstromquelle an den durch den Reststrom-Leistungsschalter geschützten Kreis angeschlossen. Des Weiteren wird aus der Gleichstromquelle ein Sättigungsgleichstrom in den durch den Reststrom-Leistungsschalter geschützten Kreis eingespeist, um die Fühlerschaltung des Reststrom-Leistungsschalters magnetisch zu sättigen und dadurch den Reststrom-Leistungsschalter zu unterbrechen, so dass dieser vorübergehend außer Betrieb genommen wird und dadurch eine Prüfung in dem Kreis ermöglicht wird.

Weitere Verfahren zur Bestimmung des Schleifenwiderstandes eines Stromversorgungsnetzes sind aus den Dokumenten DE-AS 20 35 274, DE 40 13 490 A1 und DD 274 681 A1 bekannt.

Schleifenwiderstandsmessungen dienen dazu, Aussagen über die im Netz vorkommenden Widerstände zu machen. Der Schleifenwiderstand wird durch den Außenleiter bzw. die Phase, im folgenden auch L1-Leiter genannt, und die Erde bzw. den Schutzleiter, im folgenden auch PE-Leiter genannt, bestimmt. Zu hohe Widerstände können das Auslösen des im Stromversorgungsnetz vorgesehenen Fehlerstromschutzschalters, im folgenden auch FI genannt, verhindern und damit eine Gefahr für Mensch und Tier darstellen. Durch einen zu hohen Schleifenwiderstand und den im Fehlerfall fließenden Strom können auf den Netzleitungen hohe Spannungen abfallen und Gerätegehäuse bzw. den Körper von Menschen und Tieren unter gefährliche Berührungsspannung setzen. Die Berührungsspannung darf insbesondere in kritischen Einrichtungen, beispielsweise in Krankenhäusern, 25 V nicht überschreiten.

Bei der Diskussion des Schleifenwiderstands ist zwischen zwei gängigen Netzformen zu unterscheiden, dem sogenannten TN-Netz und dem sogenannten TT-Netz.

Im TN-Netz ist der Sternpunkt des Erzeugers direkt geerdet. Die angeschlossenen Geräte sind mit dem Sternpunkt über den Schutzleiter verbunden. Die Verbindung erfolgt über den sogenannten PEN-Leiter (bezogen auf das TN-C-Netz); d.h.: gemeinsam über den Neutral- und Schutzleiter oder über einen getrennten Neutralleiter N und den Schutzleiter PE (im sogenannten TN-S-Netz). Häufig liegt eine Kombination aus beiden Netzen vor. In diesem Fall spricht man vom TN-C-S-Netz. Durch Aufbau des Netzes wird ein Körperschluß stets zu einem Kurzschluß. Der Fehlerstrom ist deshalb relativ hoch, und in vielen Fällen können als Schutzeinrichtungen Sicherungen oder Leistungsschutzschalter verwendet werden, um ein fehlerhaftes Gerät abzuschalten. Diese andere Schutzmaßnahme wird allgemein als Nullung bezeichnet. In derartigen Netzen kann davon ausgegangen werden, daß der Schleifenwiderstand sehr klein und im wesentlichen vom Innenwiderstand des Netzes bestimmt ist. Der Schleifenwiderstand ergibt sich aus dem Widerstand des L1-Leiters und des PE-Leiters sowie des PEN-Leiters.

Im einzelnen setzt sich der Schleifenwiderstand des realen TN-Netzes zusammen aus dem Generatorinnenwiderstand, den Innenwiderständen der Umspanntransformatoren, den Leitungswiderständen der Hochspannungs-Niederspannungsleitungen und den Übergangs- und Leitungswiderständen der Elektroinstallation beim Endabnehmer bzw. in einem Haus.

Für den Gesamterdungswiderstand sämtlicher Betriebserder gilt ein Wert von 2 Q als ausreichend. Damit wird erreicht, daß im Fall eines Erdschlusses eines Außenleiters die Spannung des Schutzleiters PE bzw. des PEN-Leiters gegen das Erdpotential keine unzulässig hohen Werte einnimmt. Bei Böden mit niedrigem Leitwert darf der gesamte Erdungswiderstand des Versorgungsnetzes bis zu 5 Ω betragen, wenn davon auszugehen ist, daß bei Auftreten eines Erdschlusses in einem Außenleiter auch der Erdübergangswiderstand einen entsprechend hohen Wert aufweist.

Im TT-Netz ist der Sternpunkt des Erzeugers ebenfalls direkt geerdet. Die an das Netz angeschlossenen Geräte sind mit Erdern verbunden, die von der Erdung des Erzeugers unabhängig sind. Durch den Aufbau des Netzes wird ein Körperschluß zu einem Erdschluß. Hier können bei schlechter Erdung hohe Schleifenwiderstände auftreten und somit einen Fehlerstromschutzschalter wirkungslos werden lassen. Gerade in diesem Fall macht ein Schleifenwiderstandsmeßgerät bzw. ein Verfahren zum Betreiben eines derartigen Geräts Sinn, da dadurch der maximal fließende Strom bei einem Erdschluß berechnet werden kann. Daraus kann abgeleitet werden, ob ein vorgeschalteter Fehlerstromschutzschalter oder eine Sicherung bei Einhaltung der Berührungsspannung auslösen würde. Durch die Bestimmung des Schleifenwiderstandes kann eine Aussage über die Qualität des Netzes und insbesondere über die jeweiligen Erdungsverhältnisse gemacht werden. Soll der Erdwiderstand genauer analysiert werden, ist ein spezielles Erdmeßgerät erforderlich. Der Schleifenwiderstand setzt sich zusammen aus dem Widerstand des L1-Leiters und des PE-Leiters sowie des Erdwiderstands.

Der Schleifenwiderstand des realen TT-Netzes setzt sich zusammen aus dem Generatorinnenwiderstand, den Innenwiderständen der Umspanntransformatoren, den Leitungswiderständen der Hochspannungs- und Niederspannungsleitungen, der Übergangs- und Leitungswiderstände der Elektroinstallation beim Abnehmer bzw. im Haus, und dem Widerstand des Erdreichs.

Der vorstehend angesprochene Fehlerstromschutzschalter hat die Aufgabe, Betriebsmittel innerhalb von 0,2 Sekunden allpolig abzuschalten, wenn infolge eines Isolationsfehlers eine gefährliche Berührungsspannung auftritt. Da die tatsächlichen Abschaltzeiten derartiger Schutzschalter erheblich kürzer sind, bieten Fehlerstrom-Schutzeinrichtungen einen besonders wirksamen Schutz.

Die zulässigen Höchstwerte für den Erdungswiderstand im TT-Netz hängen von der zulässigen Berührungsspannung und vom Nennfehlerstrom des Fehlerstromschutzschalters ab. Dieser Widerstand kann je nach Erdungsverhältnis hohe Werte annehmen. Im TN-Netz ist die Abschaltbedingung durch die geringe Impedanz immer gewährleistet. Da der Personenschutz mit Fehlerstromschutzschaltern sicher gewährleistet ist, finden sie immer häufiger in beiden vorstehend genannten Netzen Verwendung.

Sämtliche Leiter (die Leiter L1, L2, L3 und N), die vom Netz zu dem zu schützenden Betriebsmitteln führen, werden durch einen Summenstromwandler geführt. Da im fehlerfreien Zustand die Summe der zu- und abfließenden Ströme null ist, heben sich die magnetischen Wechselfelder der Leiter gegenseitig auf. In diesem Fall wird in der Ausgangswicklung des Summenstromwandlers keine Spannung induziert.

Bei Erdschluß eines Leiters oder bei Körperschluß eines Betriebsmittels fließt ein Teilstrom über die Erde zum Spannungserzeuger zurück. Dadurch ist die Summe der zu- und abfließenden Ströme nicht mehr gleich null. In der Ausgangswicklung des Summenstromwandlers wird deshalb eine Spannung induziert, die einen elektromagnetischen Auslöser betätigt. Dieser Auslöser schaltet das Netz allpolig. Mit einer Prüftaste kann ein Fehler simuliert werden. Damit läßt sich die Auslösefunktion des FI-Schutzschalters prüfen, nicht aber die Erdung der zu schützenden Anlage.

Die Abschaltzeit eines Fehlerstromschutzschalters darf 200 ms nicht überschreiten, wenn bei Wechselfehlerströmen der Nennfehlerstrom und bei pulsierenden Gleichfehlerströmen der 1,4-fache Nennfehlerstrom fließt. Werden diese Ströme um den Faktor 5 überschritten, müssen Fehlerstromschutzschalter innerhalb von 40 ms zuverlässig abschalten. Daraus resultiert, daß die Messung des Schleifenwiderstands innerhalb kurzer Zeit erfolgen muß, wenn mit hohen Prüfströmen gearbeitet wird.

Bekannte Verfahren zur Bestimmung des Schleifenwiderstands eines Stromversorgungsnetzes der eingangs genannten Art, bei denen der Innenwiderstand gemäß dem Differenzquotienten aus den Spannungen und Strömen bestimmt wird, sehen vor, die Schleife aus L1-Leiter und PE-Leiter mit einer Strombelastung zu beaufschlagen. Dies hat zur Folge, daß der vorhandene Fehlerstromschutzschalter durch den im PE-Leiter erzeugten Fehlerstrom zum Auslösen gebracht wird. Die bisher bekannten Meßverfahren und Meßgeräte belasten die Schleife L1-PE mit ca. 10 A Spitzenstrom während einer Halbwelle. Dieser Strom bewirkt regelmäßig die Auslösung des Fehlerstromschutzschalters.

Eine Aufgabe der Erfindung besteht angesichts dieses Standes der Technik darin, ein Verfahren zur Bestimmung des Schleifenwiderstands eines Stromversorgungsnetzes der im Oberbegriff des Anspruchs 1 bzw. des Anspruchs 7 genannten Art zu schaffen, das zuverlässig derart arbeitet, daß ein FehlerStromschutzschalter bedingt durch die Netzbelastung oder einen entsprechenden Messstrom nicht ausgelöst wird.

Gelöst wird diese Aufgabe durch ein Verfahren mit den Merkmalen des Anspruchs 1. Vorteilhafte Weiterbildungen der Erfindung sind in den Unteransprüchen angegeben.

Gemäß dem in Anspruch 1 genannten Lösungsvorschlag wird nicht wie beim Stand der Technik die Schleife L1-PE mit einem Spitzenmessstrom belastet, sondern die Schleife L1-N. Beim Lösungsvorschlag gemäß Anspruch 1 wird zusätzlich zu der Schleife L1-N die Schleife L1-PE beaufschlagt, und zwar mit einem Messstrom, der klein genug ist, um das Auslösen des Fehlerstromschutzschalters zu verhindern. Im Gegensatz hierzu kann die Schleife L1-N beliebig hoch belastet werden, ohne den Fehlerstromschutzschalter auszulösen.

Nachfolgend wird die Erfindung anhand der Zeichnung beispielhaft näher erläutert; es zeigt:

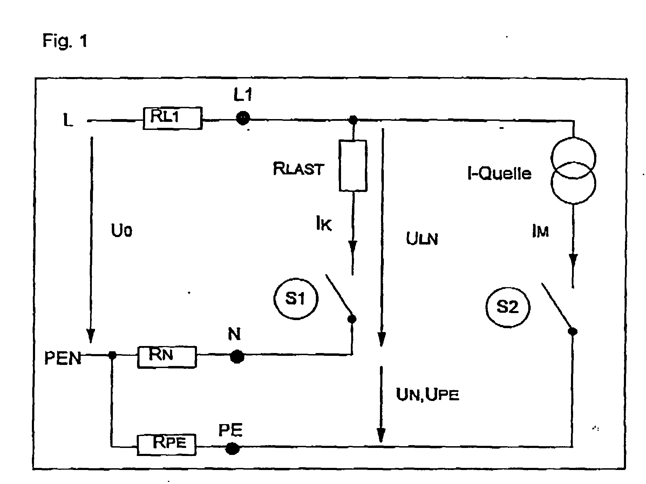

Fig. 1 ein Schaltschema zur Verdeutlichung des erfindungsgemäßen Verfahrens.

Den nachfolgend erläuterten Varianten des erfindungsgemäßen Verfahrens liegen folgende Erkenntnisse zugrunde:

Der in der PE-Leitung fließende Prüfstrom darf einen Mittelwert von 5 mA nicht überschreiten. Bei diesem Wert lösen selbst die empfindlichsten Fehlerstromschutzschalter mit Sicherheit noch nicht aus. Wird bei einem mittleren Strom von 5 mA gearbeitet, kann sich die Messung außerdem über einen relativ langen Zeitraum erstrecken.

Wird das Zeitfenster, in welchem Strom fließt, verkleinert, können auch höhere Prüfströme eingespeist werden. Messungen haben gezeigt, dass ein Prüfstrom von 1 A innerhalb einer Zeitdauer von 100 $\mu$s einen Fehlerstromschutzschalter mit 30 mA Nennfehlerstrom noch nicht auslösen lässt.

Die Messung der Spannungsdifferenz zwischen dem belasteten und unbelasteten Fall erfolgt auf zwei aufeinanderfolgende Phasen der Netzspannung. Dadurch verkleinert sich der Einfluss der Spannungsschwankungen, die im Netz auftreten können, wobei immer bei gleichen Phasenwinkeln gemessen wird.

Da niederohmige Netze Schleifenwiderstände < 1 $\Omega$ aufweisen können, ist die zu erwartende Spannungsdifferenz bei einem Strom von 1 A kleiner als 1 V. Es ist deshalb sinnvoll, Spannungsmessungen bei Phasenwinkeln durchzuführen, bei denen die Netzspannung kleine Werte aufweist. Der Dynamikumfang der entsprechenden Meßschaltung kann damit klein ausfallen.

In Fig. 1 ist ein Ersatzschaltbild für das in Rede stehende Stromversorgungsnetz gezeigt. Aus diesem Ersatzschaltbild geht hervor, daß $R_{PE}$ indirekt über den Widerstand des N-Leiters $R_N$ bestimmt werden kann, wenn ein Strom in den PE-Leiter eingespeist wird und die daraus resultierende Spannungsdifferenz $U_{NPE}$ gemessen wird.

In einem ersten Schritt wird der Widerstand $R_L$ des L-Leiters bestimmt. Die Netzleerlaufspannung $U_o$ wird bei geöffnetem Schalter S1 gemessen. Danach wird das Netz zwischen L und PEN belastet, indem der Schalter S1 geschlossen wird. Hierbei kann mit großen Strömen gearbeitet werden, da die Belastung zwischen L1 und N erfolgt.

Durch den Spannungsabfall $U_{LN}$ am Lastwiderstand $R_{last}$ und der Spannung $U_{NPE}$ errechnet sich RL1 auf indirektem Weg wie folgt:

$$I_K = U_{LN} / R_{Last} \quad ; \quad I_K = U_0 / (R_{L1} + R_N + R_{Last})$$

$$R_N = \Delta U_N / I_K$$

$$\Delta U_N = U_{NPE} \text{ (gemessen mit S1 geschlossen)} - U_{NPE} \text{ (gemessen mit S1 geöffnet)}$$

$$U_{LN}/R_{Last} \cdot (R_{L1} + R_N + R_{Last}) = U_0 \bigg| R_{Last}/U_{LN}$$

$$R_{L1} + R_N + R_{Last} = U_0/U_{LN} \cdot R_{Last}$$

$$R_{L1} = U_0/U_{LN} \cdot R_{Last} - R_N - R_{Last} \; ; \; R_N = \Delta U_N/I_K \; ;$$

$$I_K = U_{LN}/R_{Last} \quad /U_{LN}$$

$$R_{L1} = U_0/U_{LN} \cdot R_{Last} - \Delta U_N/U_{LN} \cdot R_{Last} - U_{LN}/U_{LN} \cdot R_{Last}$$

$$R_{L1} = (U_0 \cdot R_{Last} - \Delta U_N \cdot R_{Last} - U_{LN} \cdot R_{Last})/U_{LN}$$

$$\Delta U_{LN} = U_0 - U_{LN}$$

$$R_{L1} = R_{Last} \cdot (\Delta U_{LN} - \Delta U_N)/U_{LN}$$

Hierbei bedeuten:

$I_K$:     Kurzschlussstrom des Netzes
$R_{L1}$:     Strangwdst. der L-Leiter
$R_N$:     Strangwdst. der N-Leiter
$R_{PE}$:     Strangwdst. der PE-Leiter
$R_{Last}$:     Lastwdst. zur Belastung des Netzes
$U_0$:     Netzleerlaufspannung
$U_{LN}$:     Netzspannung unter Last
$\Delta U_N$:     Spannungsdifferenz am N-Leiter (belastet/unbelastet)
$\Delta U_{LN}$:     Spannungsdifferenz im Netz (belastet/unbelastet)

Im zweiten Schritt wird bei geöffnetem Schalter S1 über den Schalter S2 ein Konstantstrom ($I_M$) in den PE-Leiter ($R_{PE}$) eingespeist. Dieser liegt mit 5 mA unter dem Auslösestrom eines Fehlerstromschalters. Der Konstantstrom verursacht dabei einen Spannungsabfall $U_{PE}$ an $R_{PE}$. Dieser Spannungsabfall kann hochohmig über den N-Leiter ($R_N$) gemessen werden.
Der PE-Widerstand ergibt sich dabei als:

$$R_{PE} = U_{PE}/I_M$$

Für den Schleifenwiderstand $R_S$ gilt:

$$R_S = R_{PE} + R_{L1}$$

Ein großer Vorteil des vorstehend angeführten Verfahrens ist, dass alle im Netz vorkommenden Widerstände erfasst werden können, was auch für zukünftige Entwicklungen von großem Interesse ist.
Nachfolgend sind nochmals die in vorliegender Anmeldung verwendeten Begriffe aufgeführt:

$U_0$:     Netzleerlaufspannung des Netzes (zwischen L1-N)
$U_{LN}$:     Netzspannung unter Last (zwischen L1-N)
$\Delta U_{LN}$:     Spannungsdifferenz belastetes/unbelastetes Netz (zwischen L1-N)
$I_K$:     Kurzschlussstrom des Netzes (zwischen L1-N)
IM:     eingespeister Konstantstrom (zwischen L1-PE)
$\Delta U_N$:     Spannungsdifferenz am N-Leiter (zwischen N-PE), bei L1-PE mit $I_M$ belastet/unbelastet
$U_{PE}$:     Spannungsabfall am PE-Leiter aufgrund IM (zwischen N-PE)
$R_{L1}$:     Strangwdst. des L-Leiters
$R_n$:     Strangwdst. des N-Leiters
$R_{PE}$:     Strangwdst. des PE-Leiters
$R_{Last}$:     Lastwiderstand zur Belastung des Netzes
$R_S$:     Schleifenwiderstand

**Patentansprüche**

1. Verfahren zur Bestimmung des Schleifenwiderstandes ($R_S$) eines Stromversorgungsnetzes mit einem Neutralleiter (N), einem Außenleiter (L1), einem Schutzleiter (PE) und einem Fehlerstromschutzschalter (FI), **gekennzeichnet durch**:

    a. Eine erste Messung mit den Schritten:

        i. Messen einer ersten Spannung ($U_o$) zwischen dem Au-ßenleiter (L1) und dem Neutralleiter (N) und einer zweiten Spannung ($U_{NPE}$) zwischen dem Neutralleiter (N) und dem Schutzleiter (PE), wobei eine erste Schleife zwischen Außenleiter (L1) und Neutralleiter (N) geöffnet ist;
        ii. Anschalten eines Lastwiderstandes ($R_{Last}$) zum Schließen der ersten Schleife ($L_1$ - N);
        iii. Messen der ersten Spannung ($U_{LN}$) zwischen dem Au-ßenleiter (L1) und dem Neutralleiter (N) und der zweiten Spannung ($U_{NPE}$) zwischen dem Neutralleiter (N) und dem Schutzleiter (PE) bei jeweils geschlossener erster Schleife;
        iv. Bestimmen des Strangwiderstandes des Außenleiters ($R_{L1}$) gemäß Gleichung (1):

$$R_{L1} = R_{LAST} \; (\Delta U_{LN} - \Delta U_N)/U_{LN} \qquad\qquad (1)$$

    wobei
    $\Delta U_{LN} = U_O - U_{LN}$ (Netzspannung unter Last)
    $\Delta U_N = U_{NPE}$ (erste Schleife geschlossen) $- U_{NP}E$ (erste Schleife geöffnet)
    b. Eine zweite Messung mit den Schritten:

        i. Belasten einer zweiten Schleife zwischen Außenleiter ($L_1$) und Schutzleiter (PE) mit einem Messstrom ($I_M$), der klein genug ist, um ein Auslösen des Fehlerstromschutzschalters (FI) zu vermeiden,
        ii. Messen einer Spannung ($U_{PE}$) zwischen dem Neutralleiter (N) und dem Schutzleiter (PE) in belastetem Zustand,
        iii. Bestimmen des Strangwiderstandes ($R_{PE}$) des Schutzleiters (PE) gemäß Gleichung (2):

$$R_{PE} = U_{PE} \; / \; I_M \qquad\qquad (2)$$

    c. Die Bestimmung des Schleifenwiderstandes ($R_S$) als Summe der ermittelten Strangwiderstände des Außenleiters ($R_{LI}$) und des Schutzleiters ($R_{PE}$) gemäß Gleichung (3):

$$R_S = R_{L1} + R_{PE} \qquad\qquad (3).$$

2. Verfahren nach Anspruch 1,
**dadurch gekennzeichnet, dass** der Messstrom $I_M$ in der Größenordnung von Milliampere liegt und vor allem etwa 5 mA beträgt.

3. Verfahren nach Anspruch 1 oder 2,
**dadurch gekennzeichnet, dass** der Messstrom $I_M$ ein Gleichstrom ist.

4. Verfahren nach Anspruch 1 oder 2,
**dadurch gekennzeichnet, dass** der Messstrom $I_M$ ein Wechselstrom ist.

5. Verfahren nach Anspruch 3 oder 4,

**dadurch gekennzeichnet, dass** der Messstrom $I_M$ einer externen Stromversorgung entnommen ist.

6. Verfahren nach Anspruch 3 oder 4,
   **dadurch gekennzeichnet, dass** der Messstrom $I_M$ dem Stromversorgungsnetz entnommen ist.

7. Verfahren nach einem der Ansprüche 1 bis 6,
   **dadurch gekennzeichnet, dass** die Berechnung mittels analogen Addierern und Multiplizierern erfolgt.

8. Verfahren nach einem der Ansprüche 1 bis 6,
   **dadurch gekennzeichnet, dass** die Berechnungen durch einen Mikroprozessor gesteuert digital erfolgt.

**Claims**

1. A method for determining the loop resistance ($R_S$) of a power supply network having a neutral conductor (N), an external conductor (L1), a protective earth conductor (PE), and a residual-current circuit breaker (FI), **characterised by**:

   a. A first measurement having the following steps:

   i. measuring a first voltage ($U_O$) between the external conductor (L1) and the neutral conductor (N) and a second voltage ($U_{NPE}$) between the neutral conductor (N) and the protective earth conductor (PE), whereby a first loop is opened between the external conductor (L1) and the neutral conductor (N);
   ii. connecting a load resistance ($R_{load}$) for closing the first loop ($L_1$ - N);
   iii. measuring the first voltage ($U_{LN}$) between the external conductor (L1) and the neutral conductor (N) and the second voltage ($U_{NPE}$) between the neutral conductor (N) and the protective earth conductor (PE) with the first loop closed in each case;
   iv. determining the phase resistance of the external conductor ($R_{LI}$) according to equation (1):

   $$R_{LI} = R_{LOAD} \ (\Delta U_{LN} - \Delta U_N)/U_{LN} \qquad (1)$$

   where
   $\Delta U_{LN} = U_O - U_{LN}$ (line voltage under load)
   $\Delta U_N = U_{NPE}$ (first loop) - $U_{NP}E$ (first loop open)
   b. A second measurement having the following steps:

   i. loading a second loop between the external conductor ($L_1$) and the protective earth conductor (PE) with a measuring current ($I_M$) that is small enough to avoid triggering the residual-current circuit breaker (FI),
   ii. measuring a voltage ($U_{PE}$) between the neutral conductor (N) and the protective earth conductor (PE) in the loaded state,
   iii. determining the phase resistance ($R_{PE}$) of the protective earth conductor (PE) according to equation (2):

   $$R_{PE} = U_{PE} \ / \ I_M \qquad (2)$$

   c. Determining the loop resistance ($R_S$) as the sum of the determined phase resistance of the external conductor ($R_{LI}$), and of the protective earth conductor ($R_{PE}$) according to equation (3):

   $$R_S = R_{LI} + R_{PE} \qquad (3).$$

2. A method according to Claim 1,
   **characterised in that** the measuring current $I_M$ is in the order of magnitude of milliamperes and is in particular approximately 5 mA.

3. A method according to Claim 1 or 2,
   **characterised in that** the measuring current $I_M$ is a direct current.

4. A method according to Claim 1 or 2,
   **characterised in that** the measuring current $I_M$ is an alternating current.

5. A method according to Claim 3 or 4,
   **characterised in that** the measuring current $I_M$ is taken from an external power supply.

6. A method according to Claim 3 or 4,
   **characterised in that** the measuring current $I_M$ is taken from the power supply network.

7. A method according to one of Claims 1 to 6,
   **characterised in that** the calculations are performed using analogue adders and multipliers.

8. A method according to one of Claims 1 to 6,
   **characterised in that** the calculations are performed digitally, controlled by a microprocessor.


**Revendications**

1. Procédé pour déterminer la résistance en boucle $R_S$ d'un réseau d'alimentation électrique comportant un conducteur neutre N, un conducteur extérieur L1, un conducteur de protection PE et un disjoncteur de courant de défaut FI,
   **caractérisé en ce que**

   a. on effectue une première mesure selon les étapes suivantes :

   i. mesure d'une première tension $U_0$ entre le conducteur extérieur L1 et le conducteur neutre N et une seconde tension $U_{NPE}$ entre le conducteur neutre N et le conducteur de protection PE, la première boucle entre le conducteur extérieur L1 et le conducteur neutre N étant ouverte ;
   ii. branchement d'une résistance de charge $R_{LAST}$ pour fermer la première boucle $L_1$ - N ;
   iii. mesure de la première tension $U_{LN}$ entre le conducteur extérieur L1 et le conducteur neutre N et la seconde tension $U_{NPE}$ entre le conducteur neutre N et le conducteur de protection PE, avec toutefois la première boucle fermée ;
   iv. détermination de la résistance de phase du conducteur extérieur $R_{LI}$ selon l'équation 1 suivante :

   $$R_{L1} = R_{LAST} \, (\Delta U_{LN} - \Delta U_N) \, / \, U_{LN} \qquad (1)$$

   dans laquelle :
   $\Delta U_{LN} = U_0 - U_{LN}$ (tension du réseau de sous charge)
   $\Delta U_N = U_{NPE}$ (première boucle fermée) - $U_{NP}E$ (première boucle ouverte) ;
   b. une seconde mesure avec les étapes suivantes :

   i. application à une seconde boucle entre le conducteur extérieur L1 et le conducteur de protection PE d'un courant de mesure $I_M$ suffisamment faible pour éviter le déclenchement du disjoncteur du courant de défaut FI ;
   ii. mesure d'une tension $U_{PE}$ entre le conducteur neutre N et le conducteur de protection PE à l'état de charge ;
   iii. détermination de la résistance entre phase $R_{PE}$ du conducteur de protection PE selon l'équation 2 suivante :

   $$R_{PE} = U_{PE} \, / \, I_M$$

   c. détermination de la résistance de boucle $R_S$ comme somme des résistance de boucle obtenue pour le conducteur extérieur $R_{LI}$ et du conducteur de protection $R_{PE}$ selon l'équation 3 suivante :

$$R_S = R_{L1} + R_{PE}$$

**2.** Procédé selon la revendication 1,
**caractérisé en ce que**
le courant de mesure $I_M$ se situe dans un ordre de grandeur des milliampères et notamment de l'ordre de 5 mA.

**3.** Procédé selon la revendication 1 ou 2,
**caractérisé en ce que**
le courant de mesure $I_M$ est un courant continu.

**4.** Procédé selon la revendication 1 ou 2,
**caractérisé en ce que**
le courant de mesure $I_M$ est un courant alternatif.

**5.** Procédé selon les revendications 3 ou 4,
**caractérisé en ce que**
le courant de mesure $I_M$ est fourni par une alimentation externe.

**6.** Procédé selon les revendications 3 ou 4,
**caractérisé en ce que**
le courant de mesure $I_M$ est fourni par le réseau d'alimentation électrique.

**7.** Procédé selon l'une des revendications 1 à 6,
**caractérisé en ce que**
le calcul est fait à l'aide d'additionneurs et de multiplicateurs analogiques.

**8.** Procédé selon l'une des revendications 1 à 6,
**caractérisé en ce que**
les calculs sont faits à l'aide d'un micro processeur à commande numérique.

Fig. 1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0295800 B1
- DE 2035274 B
- DE 4013490 A1
- DD 274681 A1